# EUROPÄISCHE PATENTSCHRIFT

(11) **EP 0 903 858 B1**
(45) Veröffentlichungstag und Bekanntmachung des Hinweises auf die Patenterteilung: **22.12.2004**
(21) Anmeldenummer: 98116858.6
(22) Anmeldetag: 07.09.1998
(51) Int. Cl.: H03K 23/66

(54) **Frequenzteiler mit geringem Stromverbrauch**
Low-consumption frequency divider
Diviseur de fréquence à faible consommation

(30) Priorität: 18.09.1997 DE 19741208
(43) Veröffentlichungstag der Anmeldung: 24.03.1999
(73) Patentinhaber: Infineon Technologies AG, 81669 München (DE)
(72) Erfinder: Knapp, Herbert, 80798 München (DE)
(74) Vertreter: Epping Hermann & Fischer

(56) Entgegenhaltungen:
- DE-A- 3 324 506
- DE-B- 2 935 907
- CRANINCKX J ET AL: "A 1.75-GHZ/3-V DUAL-MODULUS DIVIDE-BY-128/129 PRESCALER IN 0.7-MUM CMOS" IEEE JOURNAL OF SOLID-STATE CIRCUITS, Bd. 31, Nr. 7, 1. Juli 1996 (1996-07-01), Seiten 890-897, XP000632373 ISSN: 0018-9200
- ANDRZEJ PARTYKA: "frequency divider generates 50% duty cycle" EDN ELECTRICAL DESIGN NEWS., Bd. 32, Nr. 18, 3. September 1987 (1987-09-03), Seiten 244-246, XP002120241 CAHNERS PUBLISHING CO. NEWTON, MASSACHUSETTS. 81963 1, US ISSN: 0012-7515

## Beschreibung

Unter dem Begriff Frequenzteiler sollen hier insbesondere sogenannte Dual Modulus Prescaler" verstanden werden, wie sie in Frequenzsynthesizern von mobilen Telekommunikationssystemen. Verwendung finden. Solche Frequenzteiler weisen zwischen 1/N und 1/(N + 1) umschaltbare Teilungsfaktoren auf, wobei N typischerweise 64 oder 128 beträgt, arbeiten mit Frequenzen in der Größenordnung von 1 GHz und sind Bestandteil eines jeden GSM- oder DECT-Telefons. Wegen der üblicherweise vorhandenen Batterieversorgung der Geräte ist ein geringer Stromverbrauch von ganz wesentlicher Bedeutung.

Beispiele für die Verwendung und den Aufbau solcher Prescaler sind aus dem IEEE Journal of Solid-State Circuits, Vol. 29, No. 10, Oktober 1994, p. 1206 bis 1211 sowie Vol. 27, No. 12, Dezember 1992, p. 1794 bis 1798, bekannt, wobei jeweils einem synchronen 1:4/5-Teiler weitere asynchrone Teilererweiterungsstufen nachgeschaltet sind.

In dem Artikel von Craninckx, J. et al.: "A 1.75/GHZ/3-V Dual-Modulus Divide-By 128/129 Prescaler in 0.7-MUM CMOS", IEEE Journal of Solid-State Circuits, Bd. 31, Nr. 7, 1. Juli 1996, Seiten 890-897 wird ein Frequenzteiler beschrieben, der eingangsseitig einen Frequenzhalbierer aufweist, der aus einem Eingangssignal mit einer Frequenz Fin ein Zwischensignal bildet, das lediglich die halbe Frequenz F2 aufweist. Dem Frequenzhalbierer ist ein weiterer Frequenzhalbierer in der Form eines Master-Slave-Flipflops nachgeschaltet, das vier aus Ausgangssignale zur Verfügung stellt. Diese weisen 1/4 der Eingangsfrequenz Fin auf und sind jeweils um 90° zueinander verschoben. Zur Erzielung eines Teilungsfaktors von 1/129 wird zyklisch bei jeder positiven Flanke des Ausgangssignals das nächste, 90° zum vorliegenden Eingangssignal der Teilerkette/32 verschobene Eingangssignal als neues Eingangssignal der Teilerkette selektiert.

Die der Erfindung zugrundeliegende Aufgabe besteht nun darin, einen Frequenzteiler der oben angegebenen Art anzugeben, der einen besonders geringen Stromverbrauch aufweist. Diese Aufgabe wird anhand der Merkmale des Patentanspruchs 1 gelöst. Der Patentanspruch 2 betrifft eine vorteilhafte Ausgestaltung der Erfindung, wobei ein Vorteil beispielsweise darin liegt, daß nur das Ausgangssignal einer Stufe des Erweiterungsteilers für das Umschalten zwischen dem Teilungsfaktor 1/N und 1/(N+1) verwendet wird und somit Strom und Chipfläche gespart wird.

Im folgenden wird anhand der Zeichnung ein bevorzugtes Ausführungsbeispiel der Erfindung näher erläutert. Dabei zeigt
- Figur 1: ein Schaltbild des bevorzugten Ausführungsbeispiels und
- Figur 2: Zeitdiagramme zur Erläuterung der Funktionsweise der Schaltung nach Figur 1.

Bei der Erfindung wird kein sonst üblicher synchroner 1:4/5-Teiler am Eingang verwendet, sondern zunächst aus dem Eingangssignal IN mit der Frequenz f ein Zwischensignal mit der Frequenz f/2 gebildet. Dies hat zur Folge, daß nicht drei Flipflops, sondern nur ein Flipflop mit der maximalen Frequenz f betrieben werden und somit bei den angegebenen Werten für N der Stromverbrauch wesentlich veringert werden kann.

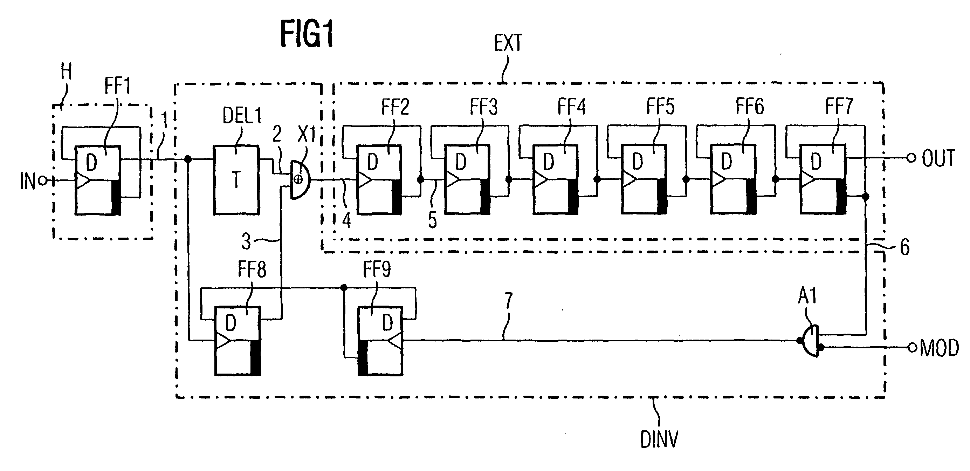

In Figur 1 ist beispielhaft ein Frequenzteiler für die Teilungsfaktoren 1/128 und 1/129 angegeben, wobei dieser einen eingangsseitigen Frequenzhalbierer H, eine Einrichtung zur synchronisierten Invertierung (DINV) und eine Teilererweiterung EXT aufweist. Der eingangsseitige Frequenzhalbierer H erzeugt aus einem Eingangssignal IN mit der Frequenz f ein Zwischensignal 1, das lediglich die Frequenz f/2 aufweist. In der Einrichtung DINV wird abhängig von einem Steuersignal MOD im Falle eines gewünschten Teilungsfaktors 1/N = 1/128 direkt auf einen Takteingang einer ersten Stufe der Teilererweiterung EXT durchgeschaltet, der ein Taktsignal 4 führt. Falls der Teilungsfaktor 1/(N + 1) = 1/129 gewünscht wird, wird durch das Steuersignal MOD das Zwischensignal 1 nach N Perioden invertiert und dadurch um die halbe Periodendauer des Zwischensignals 1 verzögert auf den Takteingang der Teilererweiterung durchgeschaltet. Das Ausgangssignal OUT wird in beiden Fällen vom Ausgang der letzten Stufe FF7 der Teilererweiterung EXT abgenommen.

Der in Figur 1 dargestellte Frequenzhalbierer H besteht hier aus einem durch positive Flanken triggerbaren D-Flipflop FF1, dessen invertierter Ausgang auf den Eingang D rückgekoppelt ist, dessen Takteingang mit dem Eingangssignal IN des Frequenzteilers beschaltet ist und dessen nicht invertierter Ausgang das Zwischensignal 1 der Frequenz f/2 liefert. Das Zwischensignal 1 wird einem Eingang eines Verzögerungsglieds DIN1 und einem Triggereingang eines ersten Halteglieds FF8 zugeführt. Das Ausgangssignal 2 des Verzögerungsglieds, das dieselbe Durchlaufzeit wie das erste Halteglied FF8 aufweist, ist einem ersten Eingang und ein nicht invertiertes Ausgangssignal des ersten Haltegliedes FF8 einem zweiten Eingang des EXOR-Gatters X1 zugeführt, dessen Ausgang das Taktsignal 4 für die Teilererweiterung liefert. Die Teilererweiterung EXT besteht hierbei aus Flipflops FF2 bis FF7 und bildet einen asynchronen Frequenzteiler mit dem Teilungsfaktor 1/2⁶. Das EXOR-Gatter dient hierbei als gesteuerter Inverter, wobei bei Low-Pegel am zweiten Eingang das Zwischensignal 1 unverändert das Taktsignal 4 für das Flipflop FF2 bildet. Bei High-Pegel hingegen invertiert das EXOR-Gatter X1 das Taktsignal 4 des Flipflops F2. Da der zweite Eingang des EXOR-Gatters mit dem Ausgang des Flipflops FF8 verbunden ist, entscheidet der Zustand des Flipflops FF8, ob das Signal 2 invertiert wird oder nicht. Solange das Steuersignal MOD High-Pegel aufweist, bleibt der Ausgang der NAND-Schaltung A1 auf High und damit behalten auch die Flipflops FF8 und FF9 ihren jeweiligen Zustand bei. Die Flipflops FF1 bis FF7 arbeiten daher als Frequenzteiler mit dem Teilungsfaktor 1/2⁷ bzw. 1/128. Weist das Steuersignal MOD Low-Pegel auf, ändert bei jeder Taktperiode des Ausgangssignals OUT das Flipflop FF9 und damit auch das Flipflop FF8 seinen Zustand. Jede Änderung am Ausgang des Flipflops FF8 bewirkt eine Invertierung des Taktsignals 4 bezogen auf den vorhergehenden Zustand, was einer Phasenverschiebung um 180° entspricht. Da die Frequenz am Eingang des Flipflops FF2 halb so groß ist wie am Eingang des Frequenzteilers entspricht das einer Phasenverschiebung um 360° oder einer Periode bezogen auf die Eingangsfrequenz. Diese Vebschiebung um eine Periode bewirkt die gewünschte Umschaltung des Teilungsfaktors von 1/128 auf 1/129.

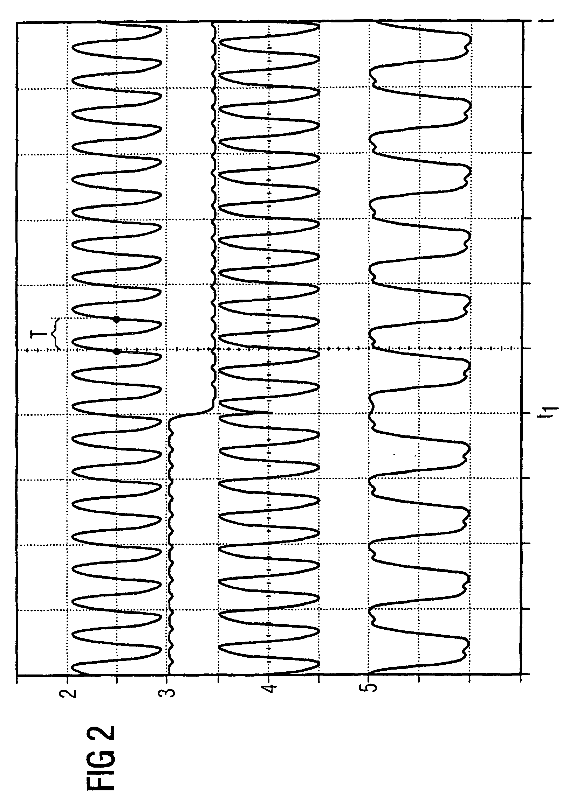

Figur 2 zeigt ein Zeitdiagramm der Signale 2 ... 5, wobei das Signal 2 wegen der hohen Frequenz nicht mehr rechteckförmig, sondern annähernd sinusförmig ist und die Periodendauer T aufweist. Das Signal 3 schaltet zu einem Zeitpunkt t₁ von einem Highpegel auf einen Lowpegel um. Das Signal 4 weist zum Zeitpunkt t1 einen Phasensprung von 180° auf. Das Signal 5 am Ausgang des Flipflops FF2 wechselt daher erst verzögert von High auf Low. Die Verzögerung entspricht dabei genau einer Periode der Eingangsfrequenz. Das Flipflop FF8 stellt sicher, daß die Invertierung genau im Nulldurchgang des Signals 2 stattfindet. Dies ist erforderlich, um das Auftreten von kurzen Störimpulsen im Ausgangssignal 4 des EXOR-Gatters im Umschaltzeitpunkt zu verhindern. Das Flipflop FF8 wird deshalb vom Zwischensignal 1 getriggert. Das Verzögerungselement DEL1 bildet die Durchlaufzeit des Flipflops FF8 nach, so daß ein Pegelwechsel des Flipflops FF8 immer zeitlich mit einem Pegelwechsel des Signals 2 zusammenfällt.

## Patentansprüche

1. Frequenzteiler
- mit einem eingangsseitigen Frequenzhalbierer (H), der aus einem Eingangssignal (IN) mit der Frequenz f ein Zwischensignal (1) bildet, das lediglich die Frequenz f/2 aufweist, und
- mit einer mittels eines Steuersignals (MOD) ansteuerbaren Schaltvorrichtung sowie einer Teilererweiterung (EXT), **dadurch gekennzeichnet, dass**
- die Schaltvorrichtung als Einrichtung zur synchronisierten Invertierung (DINV) ausgebildet ist, die abhängig von dem Steuersignal (MOD), im Falle eines gewünschten Teilungsfaktors 1/N das Zwischensignal (1) direkt auf einen Eingang einer Teilererweiterung (EXT) durchschaltet und die im Falle eines gewünschten Teilungsfaktors 1/(N+1) das Zwischensignal nach N Perioden invertiert und mit einem Phasensprung um 180° bezüglich des Zwischensignals (1) auf den Eingang der Teilererweiterung durchschaltet, wobei ein Ausgang der Teilererweiterung ein Ausgangssignal (OUT) mit der Frequenz f/N bzw. f/(N+1) liefert.

2. Frequenzteiler nach Anspruch 1,
- bei dem die Einrichtung (DINV)zur synchronisierten Invertierung ein Verzögerungsglied (DEL1), ein erstes Halteglied (FF8), ein zweites Halteglied (FF9), ein EXOR-Gatter (X1) und ein NAND-Gatter (A1) aufweist,
- bei dem ein ein invertiertes Ausgangssignal (6) einem ersten Eingang und das invertierte Steuersignal (MOD) einem zweiten Eingang des NAND-Gatters zugeführt sind und ein Ausgang des NAND-Gatters ein Triggersignal (7) für das zweite Halteglied liefert, dessen invertierter Ausgang mit jeweils mit dem Eingang des ersten und zweiten Haltegliedes verbunden ist,
- bei dem das Zwischensignal (1) einem Eingang des Verzögerungsglieds und einem Triggereingang des ersten Halteglieds zugeführt ist und
- bei dem ein Ausgangssignal (2) des Verzögerungsglieds, das die selbe Durchlaufzeit wie das erste Halteglied aufweist, einem ersten Eingang und ein nichtinvertiertes Ausgangssignal (3) des ersten Halteglieds einem zweiten Eingang des EXOR-Gatters zugeführt ist, dessen Ausgang ein Triggersignal (4) für die Teilererweiterung liefert.

## Claims

1. Frequency divider
- having an input-side frequency halver (H) which forms an intermediate signal (1) from an input signal (IN) at the frequency f, which intermediate signal has only the frequency f/2, and
- having a switching apparatus, which can be driven by means of a control signal (MOD), as well as a divider extension (EXT),
**characterized in that**
- the switching apparatus is in the form of a device for synchronized inversion (DINV) which passes on the intermediate signal (1) directly to one input of a divider extension (EXT) as a function of the control signal (MOD) in the event of a desired division factor 1/N, and which inverts the intermediate signal after N periods in the event of a desired division factor 1/(N+1) and passes it on with a phase shift of 180° with respect to the intermediate signal (1) to the input of the divider extension, with one output of the divider extension producing an output signal (OUT) at the frequency f/N or f/(N+l).

2. Frequency divider according to Claim 1,
- in which the device (DINV) for synchronized inversion has a delay element (DEL1), a first hold element (FF8), a second hold element (FF9) an EXOR gate (Xl) and a NAND gate (Al),
- in which an inverted output signal (6) is supplied to a first input and the inverted control signal (MOD) is supplied to a second input of the NAND gate, and one output of the NAND gate produces a trigger signal (7) for the second hold element, whose inverted output is in each case connected to the input of the first and of the second hold element,
- in which the intermediate signal (1) is supplied to one input of the delay element and to a trigger input of the first hold element, and
- in which an output signal (2) from the delay element, which has the same delay time as the first hold element, is supplied to a first input, and a non-inverting output signal (3) from the first hold element is supplied to a second input of the EXOR gate, whose output produces a trigger signal (4) for the divider extension.

## Revendications

1. Diviseur de fréquence
- comprenant du côté de l'entrée un circuit (H) divisant la fréquence par deux et formant à partir d'un signal (IN) d'entrée, de fréquence f, un signal (1) intermédiaire qui a seulement la fréquence f/2 et
- comprenant un dispositif de commutation qui peut être commandé au moyen d'un signal (MOD) de commande, ainsi qu'une extension (EXT) de diviseur,
**caractérisé en ce que**
le dispositif de commutation est constitué en dispositif d'inversion (DINV) synchronisé qui, en fonction du signal (MOD) de commande, envoie, dans le cas d'un facteur 1/N de division souhaité, le signal (1) intermédiaire directement à une entrée d'une extension (EXT) de diviseur et qui, dans le cas d'un facteur 1/(N+1) de division souhaité, inverse le signal intermédiaire après N périodes et l'envoie avec un saut de phase de 180° par rapport au signal (1) intermédiaire à l'entrée de l'extension de diviseur, une sortie de l'extension de diviseur fournissant un signal (OUT) de sortie ayant la fréquence f/N ou f/(N+1).

2. Diviseur de fréquence suivant la revendication 1,
dans lequel le dispositif (DINV) d'inversion synchronisée a un élément (DEL1) de temporisation, un premier élément (FF8) de maintien, un deuxième élément (FF9) de maintien, une porte (X1) OU EXCLUSIF et une porte (A1 ) NON ET,
- dans lequel un signal (6) inversé de sortie est envoyé à une première entrée et le signal (MOD) inversé de commande à une deuxième entrée de la porte NON ET et une sortie de la porte NON ET fournit un signal (7) de déclenchement pour le deuxième élément de maintien, dont la sortie inversée est reliée à respectivement l'entrée du premier et du deuxième élément de maintien,
- dans lequel le signal (1) intermédiaire est envoyé à une entrée de l'élément de temporisation et à une entrée de déclenchement du premier élément de maintien, et
- dans lequel un signal (2) de sortie de l'élément de temporisation, qui a le même temps de passage que le premier élément de maintien, est envoyé à une première entrée et un signal (3) non inversé de sortie du premier élément de maintien à une deuxième entrée de la porte OU EXCLUSIF, dont la sortie fournit un signal (4) de déclenchement pour l'extension de diviseur.
